# EUROPEAN PATENT SPECIFICATION

(11) **EP 1 876 461 B1**
(45) Date of publication and mention of the grant of the patent: **17.06.2009**
(21) Application number: 07009427.1
(22) Date of filing: 04.04.2001
(51) Int. Cl.: G01R 31/36, G01N 27/416

(54) **Current measuring apparatus for battery**
Strommessvorrichtung für eine Batterie
Appareil de mesure de courant pour batterie

(30) Priority: 04.04.2000 US 194435 P
(43) Date of publication of application: 09.01.2008
(62) Divisional of application: 01923113.3
(73) Proprietor: Microchip Technology Incorporated, Chandler, AZ 85224-6199 (US)
(72) Inventor: Batson, David C., Winchester MA 01890 (US)
(74) Representative: Grubert, Andreas

(56) References cited:
- EP-A- 0 355 461
- CH-A- 678 469
- US-A- 4 707 795
- US-A- 5 451 881
- US-A- 5 629 680
- US-A- 5 841 284
- US-A- 6 037 749

## Description

### Cross-Reference to Related Applications

The present application claims priority to provisional U.S. patent application serial number 60/194,435, filed April 4, 2000, which is assigned to the assignee of the present disclosure and incorporated herein by reference.

### Background of Disclosure

### 1. Field of Disclosure

The present disclosure relates to batteries and, more particularly, to an apparatus for measuring current flow to and from a terminal post of a battery.

### 2. Related Art

The present disclosure is described in conjunction with a lead-acid battery of the type used to provide starting power in vehicles, such as automobiles, trucks and motorcycles. This type of battery generally includes a plastic casing containing positive and negative lead plates immersed in an acid electrolyte. The plates are separated by nonconductive sheets, and a positive lead strap connects the positive plates while a negative lead strap connects the negative plates. Lead posts are connected to each strap and extend through the casing, and lead positive and negative battery terminals are secured to the ends of the posts outside the casing for receiving cable connectors.

Presently, means for monitoring the status of batteries normally measures the voltage provided between the battery terminals. However, battery voltage in itself provides limited information as to battery status and performance. What is desired instead is an apparatus for monitoring the flow of current into and out of the battery. The current flow can then be used over time to calculate and monitor the level of charge of the battery. Preferably, the apparatus will be simple in design, and easily incorporated in a battery.

Different measurement devices are know from US-A-4707795, CH 678469A, US-A-5451881, US-A-4841284, US-A-5629680 and EP-A-0355461. However, none of these documents discloses a measurement device that can be used without modification of the entire system.

### Summary of Disclosure

It is, therefore, an object of the present invention to provide a convenient device and or a battery with a measuring device for obtaining in formation of the current flowing in and out of a battery. This object can be achieved by the features as defined in the independent claims. Further enhancements are defined in the dependent claims.

In response, the present disclosure provides an apparatus for measuring electrical energy passing to and from a battery post. The apparatus includes a resistor for providing an electrical connection to a battery post, and the resistor has a known resistance, a first conducting surface and a second conducting surface. The conducting surfaces are arranged such that current flow from the post will travel through the resistor from the first conducting surface to the second conducting surface, and current flow to the post travels through the resistor from the second to the first conducting surfaces. The energy measuring apparatus further includes a first lead electrically connected to the first conducting surface of the resistor, and a second lead electrically connected to the second conducting surface of the resistor.

According to one aspect of the present disclosure, the apparatus further includes a volt meter connected between the first and the second leads for measuring a voltage drop across the resistor.

According to another aspect, the apparatus further includes a computer having memory for storing the known resistance of the resistor, and a processor programmed to receive the measured voltage drop from the volt meter, retrieve the known resistance from the memory, and calculate current flow through the resistor based on the measured voltage drop and the known resistance.

The present disclosure also provides a battery including the measuring apparatus, and further including a case, a storage cell contained within the case for receiving and storing an electrical charge, and an electrically conductive post connected to the storage cell and extending out of the case. The first conducting surface of the resistor is positioned on a portion of the post extending out of the case.

According to an aspect of the present disclosure, the storage cell of the battery includes lead and lead-oxide plates immersed in an acid electrolyte.

These and other aspects of the present disclosure will become apparent to those skilled in the art after a reading of the following description of the preferred embodiment when considered with the drawings.

### Brief Description of Drawings

The present disclosure is described with reference to the accompanying drawings, wherein:
FIG. 1 is a perspective view of a typical lead-acid battery constructed in accordance with the prior art, wherein a portion of an outer case of the battery is cut away to reveal an interior of the battery;
FIG. 2 is a side elevation view, partially cut-away of a post and terminal of the battery of FIG. 1;
FIG. 3 is an exploded side elevation view of the post and the terminal of the battery of FIG. 1;
FIG. 4 is an exploded side elevation view, partially cut away, of an apparatus constructed in accordance with the present disclosure including a sleeve-like resistor positioned between the post and the terminal of the battery of FIG. 1;
FIG. 5 is a perspective view of another resistor for use with the apparatus of the present disclosure;
FIG. 6 is a perspective view of an additional resistor for use with the apparatus of the present disclosure;
FIG. 7 is a side elevation view of a further resistor for use with the apparatus of the present disclosure;
FIG. 8 is a sectional view of the resistor taken along line 8--8 of FIG. 7;
FIG. 9 is a sectional view of the resistor taken along line 9--9 of FIG. 7;
FIG. 10 is a side elevation view of another resistor for use with the apparatus of the present disclosure;
FIG. 11 is a top plan view of the resistor of FIG. 10; and
FIG.12 is a sectional view of the resistor taken along line 12--12 of FIG. 11.

Like reference characters designate identical or corresponding components and units throughout the several views.

### Detailed Description of Disclosure

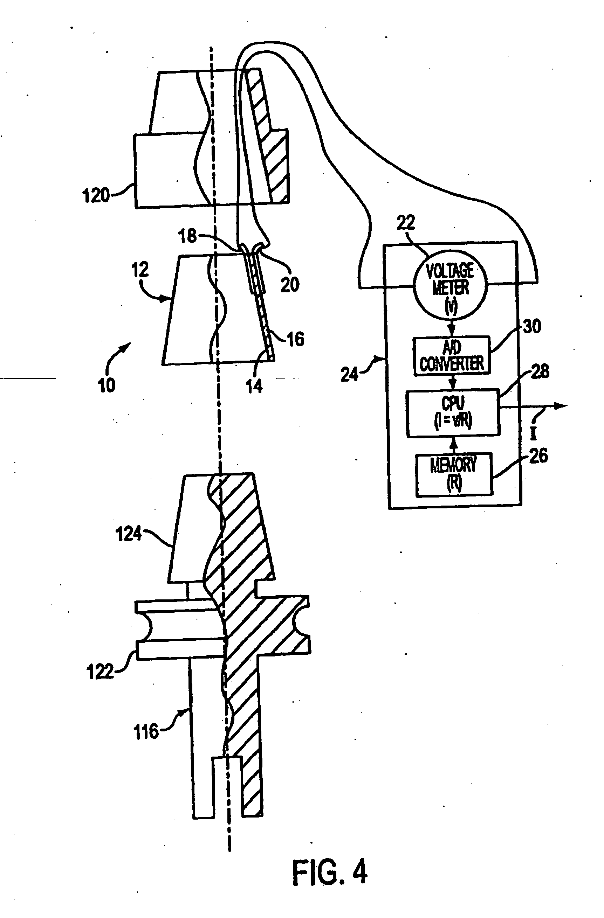

Referring now to the drawings in general, it will be understood that the illustrations are for the purpose of describing preferred embodiments of the disclosure and are not intended to limit the disclosure thereto. As shown in FIG. 4, the present disclosure provides an apparatus 10 for measuring electrical energy passing to and from a battery post 116. The apparatus 10 can be used with many different types of batteries but is described herein with reference to a lead-acid battery.

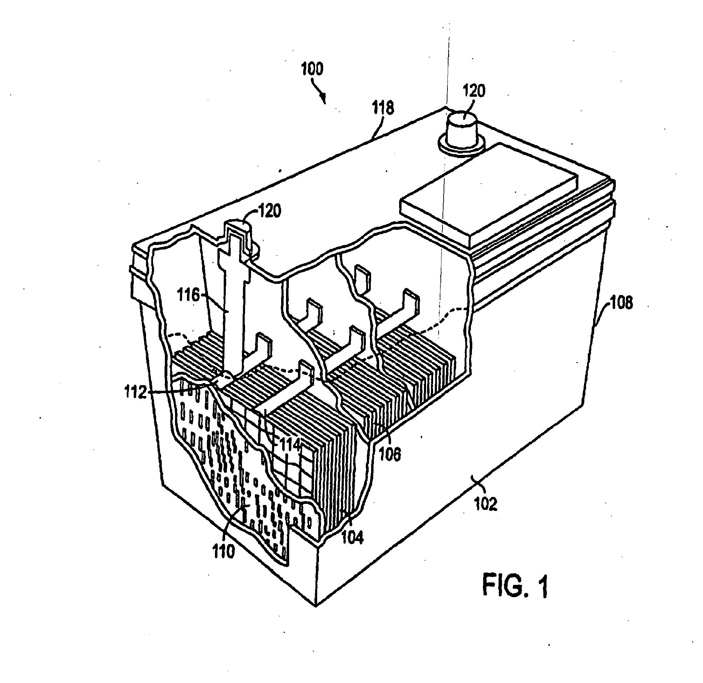

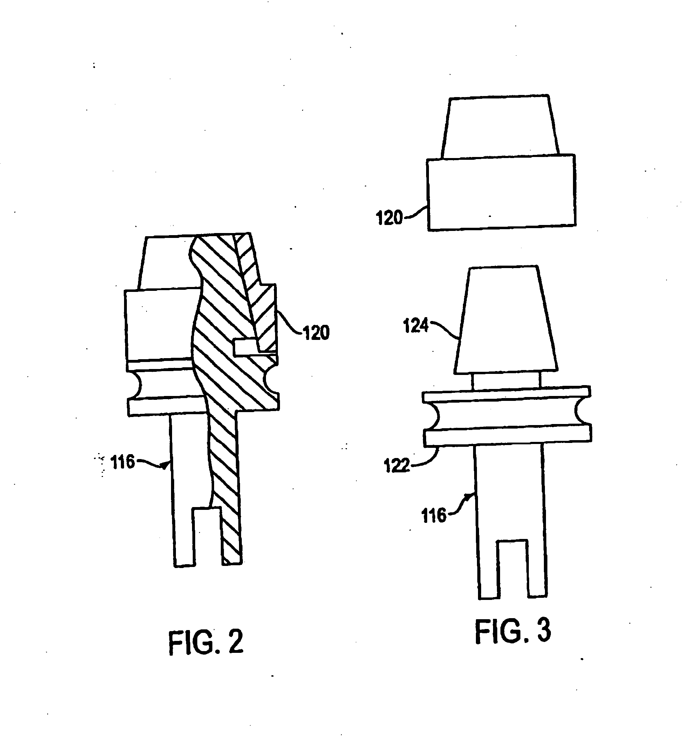

FIG. 1 shows a typical lead-acid battery, generally designated 100, for use in powering vehicles, such as trucks, automobiles and motorcycles. The battery 100 generally includes a plastic casing 102 containing positive and negative lead plates 104, 106 immersed in an acid electrolyte 108. The plates 104, 106 are separated by nonconductive sheets 110, and a positive lead strap 112 connects the positive plates 104 while a negative lead strap 114 connects the negative plates 106. A positive lead post 116 is connected to the positive strap 112, while a negative post (not shown) is connected to the negative strap 114. Both posts extend through a plastic cover 118 sealing an open top of the casing 102. As also shown in FIGS. 2 and 3, sleeve-like terminals 120 are secured to the ends of the posts outside the cover for receiving cable connectors (not shown). The terminals 120 allow cable connectors to be tightened without causing stress on the soft lead posts 116. The posts 116 can include a collar 122 for mating and providing a seal with the cover 118, and a head 124 for receiving the terminals 120.

Referring to FIG. 4, the apparatus 10 constructed in accordance with the present disclosure is for measuring electrical energy passing to and from one of the battery posts 116. The apparatus 10 includes a resistor 12 for providing an electrical connection to the battery post 116. The resistor 12 has a known resistance "R", a first conducting surface 14 and a second conducting surface 16. The conducting surfaces 14, 16 are arranged such that current flow from the post 116 will travel through the resistor 12 from the first conducting surface 14 to the second conducting surface 16, and current flow to the post 116 travels through the resistor 12 from the second to the first conducting surfaces 14,16. The energy measuring apparatus 10 further includes a first lead 18 electrically connected to the first conducting surface 14 of the resistor 12, and a second lead 20 electrically connected to the second conducting surface 16 of the resistor.

The apparatus 10 further includes a volt meter 22 connected between the first and the second leads 18, 20 for measuring a voltage drop "v" across the resistor 12, and a computer 24 having memory 26 for storing the known resistance "R" of the resistor 12, a processor 28, and an analog-to-digital converter 30 for converting an analog signal indicative of the voltage drop "v" from the volt meter 22 to a digital signal for the processor 28. The processor 28 is programmed to receive the digital signal indicative of the voltage drop "v" from the converter 30, retrieve the known resistance "R" from the memory 26, and calculate current flow "I" through the resistor 12 based on the measured voltage drop "v" and the known resistance "R". The processor 28 can be connected to an external device, such a central processing unit of an automobile, so that the external device can utilize the calculated current flow "I". Although not shown, the computer 24 can be provided with a clock and the processor 28 can be programmed to calculate the total charge of the battery based on the current flow and the charge time (when current is provided to the battery) or the drain time (when current is taken from the battery). It is envisioned that the computer 24 and the volt meter 22 can be attached to the cover 118 of the battery 100.

In the embodiment of FIG. 4, the resistor 12 is provided in the shape of a sleeve for being coaxially received between the terminal 120 and the head 124 of the battery post 116. The resistance "R" of the resistor 12 is calculated by multiplying the material volume of the resistor 12 by the resistivity of the material that the resistor 12 is made of.

The material from which the resistor is made can be lead or a non-lead material, as long as the resistance "R" of the resistor 12 is precisely known for purposes of determining current flow "I". Other conductive materials, such as copper, brass and bronze can alternatively be used. The resistor can be formed of powdered metal, stamped, machined, cast, or forged. In addition, the resistor can be plated or dipped in silver, gold, platinum or their alloys to provide a non-corrosive surface, and further dipped or coated with tin to provide better attachment between the lead post and plated resistor. The first conductive surface 14 of the resistor 12 is secured to the head 124 of the post 116, with lead solder for example, while the terminal 120 is secured to the second conductive surface 16, with lead solder for example.

As an example, the apparatus 10 is configured for use with a typical lead-acid vehicle battery to measure currents between 0.5 amperes and 1000 amperes, with the resistor 12 having a known resistance "R" of between about 50 microOhm and about 200 microOhm. Preferably, the resistor 12 is provided with a known resistance "R" of about 150 microOhm. The resistance value, of course, is determined based on a trade-off between current measurement accuracy and power dissipation at high current.

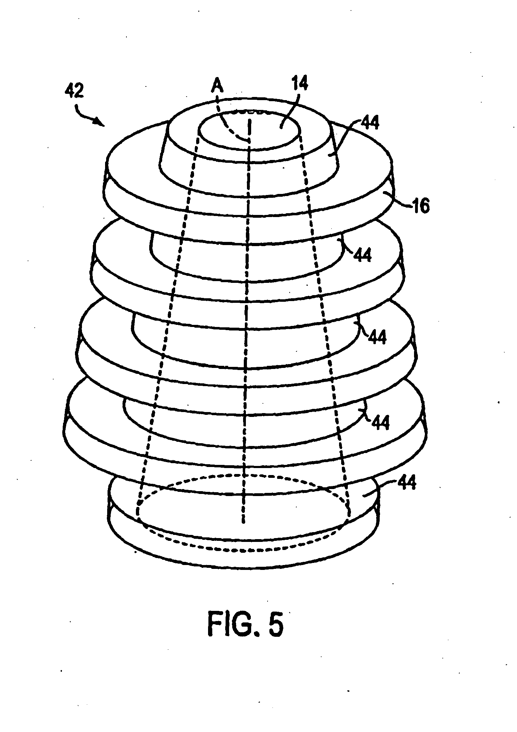

Referring to FIG. 5, another resistor 42 for use with the apparatus of FIG. 4 is shown. The resistor 42 of FIG. 5 is similar to the resistor 12 of FIG. 4 such that similar elements have the same reference numerals. The second conducting surface 16 of the resistor 42 of FIG. 5, however, includes channels 44 for dissipating heat (the wall thickness of the resistor 42 has been exaggerated for purposes of illustrating the channels). As shown, the channels 44 are circumferentially formed in the resistor 42. However, the channels could extend parallel with respect to the longitudinal axis "A" of the resistor, or spiral about the axis.

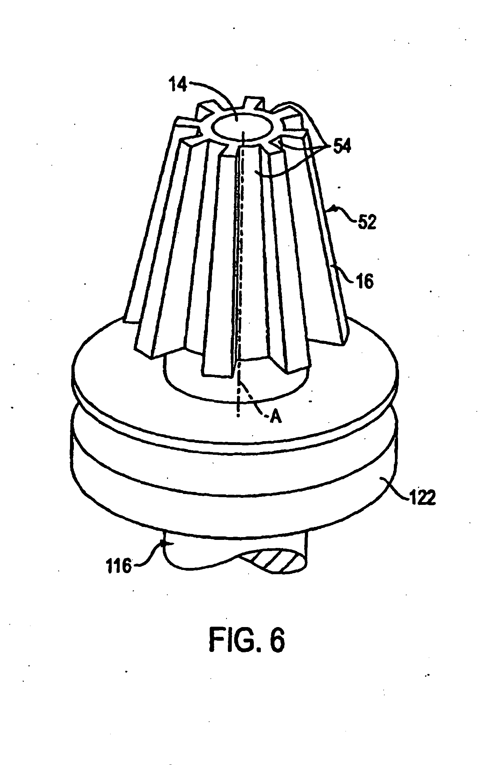

Referring to FIG. 6, another resistor 52 for use with the apparatus of FIG. 4 is shown. The resistor 52 of FIG. 6 is similar to the resistor 12 of FIG. 4 such that similar elements have the same reference numerals. As shown, the resistor 52 is integrally formed as part of the battery post 116 in place of the head of the battery post, such that the battery terminal 120 can be secure directly to the second conductive surface 16 of the resistor 52. The second conducting surface 16 of the resistor 52 includes channels 44 for dissipating heat that extend parallel with respect to the longitudinal is "A" of the resistor.

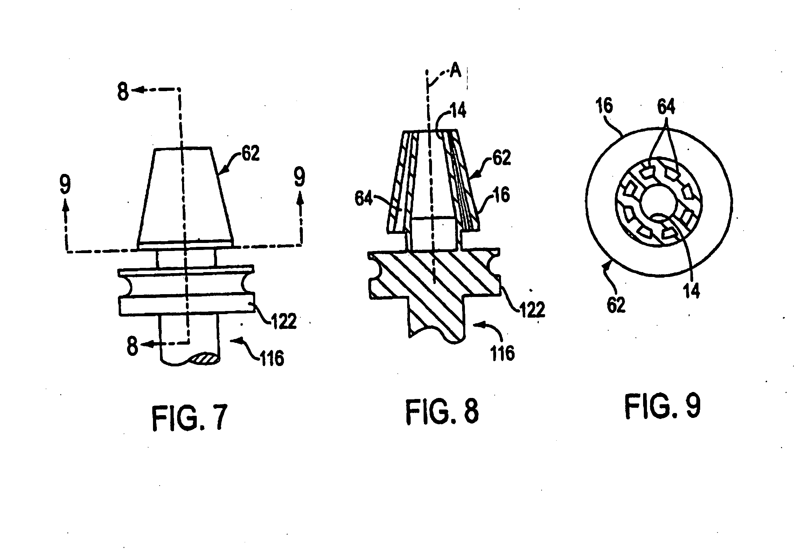

Referring to FIGS. 7, 8 and 9, another resistor 62 for use with the apparatus of FIG. 4 is shown. The resistor 62 of FIGS. 7, 8 and 9 is similar to the resistor 52 of FIG. 6 such that similar elements have the same reference numerals. As shown, the resistor 62 is integrally formed as part of the battery post 116 in place of the head of the battery post, such that the battery terminal 120 can be secure directly to the second conductive surface 16 of the resistor 62. However, the resistor 62 includes channels 64 between the first and the second conducting surfaces 14, 16. The channels 64 are for dissipating heat and extend parallel with respect to the longitudinal axis "A" of the resistor 62.

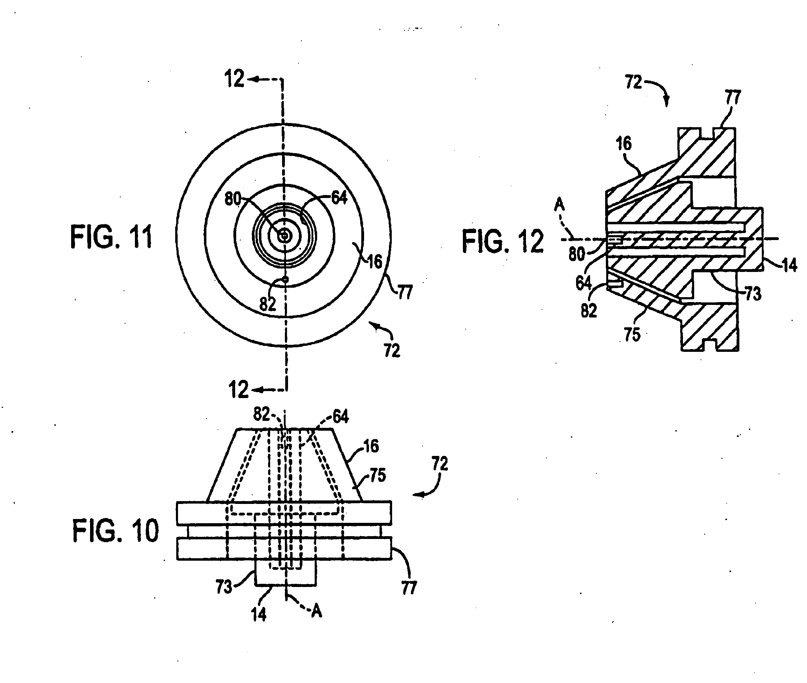

Referring to FIGS. 10, 11 and 12, another resistor 72 for use with the apparatus of FIG. 4 is shown. The resistor 72 of FIGS. 10, 11 and 12 is similar to the resistor 52 of FIG. 6 such that similar elements have the same reference numerals. As shown, the resistor 72 is formed as a collar and a head of the battery post, such that the battery terminal 120 can be secure directly to the resistor 72. The resistor 72 includes an inner portion 73 having a first conducting surface 14 of the resistor for connection to the battery post (not shown) and a sleeve-like outer portion 75, which fits over the inner portion 73 and has a second conducting surface 16 of the resistor. The outer portion 75 is secure to the inner portion 73 in a suitable manner, such as with lead solder for example. The resistor 72 also includes a single annular channel 64 within the inner portion 73 between the first and the second conducting surfaces 14,16. The channel 64 is for dissipating heat and extends parallel with respect to the longitudinal is "A" of the resistor 72. The outer portion 75 of the resistor 72 includes a collar 77 for mating and providing a seal with a cover of a battery.

The resistor 72 further includes a first bore 80 in the inner portion 73 and a second bore 82 in the outer portion 75. The bores 80, 82 are for receiving the leads 18, 20 for measuring the voltage drop between the first conducting surface 14 and the second conducting surface 16 of the resistor 72.

The present disclosure, accordingly, provides a new and improved apparatus for monitoring the flow of current into and out of a battery. As preferred, the apparatus is simple in design, relatively inexpensive and capable of manufacture in high volumes, and easily incorporated in new batteries. In addition, the presently disclosed apparatus can be retrofit into existing batteries.

Certain modifications and improvements will occur to those skilled in the art upon a reading of the foregoing description. By way of example, the resistor can be provided in place of the battery terminal, such that the cable connector would be connected directly to the resistor. Also, the first conducting surface of the resistor can include channels for dissipating heat.

## Claims

1. A battery comprising:
- a case (102);
- a storage cell contained within the case for receiving and storing an electrical charge; and
- an electrically conductive post connected to the storage cell and extending out of the case (102);
- **characterized by**
- a resistor (72) being an integral part of the electrically conductive post, the resistor (72) having a known resistance and a first conducting surface (14) and a second conducting surface (16), wherein current flow from the battery travels through the resistor (72) from the first conducting surface (14) to the second conducting surface (16) of the resistor (72) and current flow to the electrically conductive post travels through the resistor (72) from the second conducting surface (16) to the first conducting surface (14) of the resistor (72);
- a first contact (80) connected to the first conducting surface (14) of the resistor (72); and
- a second contact (82) electrically connected to the second conducting surface (16) of the resistor (72).

2. A battery according to claim 1, further comprising a computer including:
- memory (26) for storing the know resistance of the resistor (72); and
- a processor (28) programmed to,
receive the measured voltage drop from a volt meter (22) coupled with the first and second contacts (80, 82),
retrieve the known resistance from the memory (26), and
calculate current flow through the resistor (72) based on the measured voltage drop and the known resistance.

3. A battery according to one of the preceding claims 1-2, wherein the known resistance of the resistor (72) is between about 50 microOhm and about 200 microOhm.

4. A battery according to one of the preceding claims 1-3, wherein the post has an integrated sleeve-like terminal (75).

5. A battery according to one of the preceding claims 1-4, wherein the resistor (72) includes at least one channel (64) between the first and the second conducting surfaces.

6. A battery according to one of the preceding claims 1-5, wherein the resistor (72) is made from a material at least including lead.

## Patentansprüche

1. Batterie, die aufweist:
- ein Gehäuse (102);
- eine innerhalb des Gehäuses enthaltene Speicherzelle zum Aufnehmen und Speichern einer elektrischen Ladung; und
- einen elektrisch leitfähigen Anschlusspol, der mit der Speicherzelle verbunden ist und sich aus dem Gehäuse (102) heraus erstreckt;
**gekennzeichnet durch**
- einen Widerstand (72), der ein integrierter Teil des elektrisch leitfähigen Anschlusspoles ist, wobei der Widerstand (72) einen bekannten Widerstandswert und eine erste leitende Oberfläche (14) und eine zweite leitende Oberfläche (16) aufweist, wobei ein Stromfluss von der Batterie **durch** den Widerstand (72) von der ersten leitenden Oberfläche (14) zu der zweiten leitenden Oberfläche (16) des Widerstands (72) verläuft und ein Stromfluss zu dem elektrisch leitfähigen Anschlusspol **durch** den Widerstand (72) von der zweiten leitenden Oberfläche (16) zu der ersten leitenden Oberfläche (14) des Widerstands (72) verläuft;
- einen ersten mit der ersten leitenden Oberfläche (14) des Widerstands (72) verbundenen Kontakt (80); und
- einen zweiten mit der zweiten leitenden Oberfläche (16) des Widerstands (72) verbundenen Kontakt (82).

2. Batterie gemäß Anspruch 1, die weiterhin einen Computer aufweist, mit:
- Speicher (26) zum Speichern des bekannten Widerstandswertes des Widerstands (72); und
- einem Prozessor (28), der programmiert ist, um
den gemessenen Spannungsabfall von einem mit den ersten und zweiten Kontakten (80, 82) verbundenen Voltmeter (22) entgegenzunehmen,
den bekannten Widerstandswert aus dem Speicher (26) abzurufen, und
auf der Grundlage des gemessenen Spannungsabfalls und des bekannten Widerstandswertes den Stromfluss durch den Widerstand (72) zu errechnen.

3. Batterie gemäß einem der vorhergehenden Ansprüche 1 oder 2, wobei der bekannte Widerstandswert des Widerstands (72) zwischen etwa 50 Mikroohm und etwa 200 Mikroohm beträgt.

4. Batterie gemäß einem der vorhergehenden Ansprüche 1 bis 3, wobei der Anschlusspol eine integrierte hülsenartige Anschlussklemme (75) aufweist.

5. Batterie gemäß einem der vorhergehenden Ansprüche 1 bis 4, wobei der Widerstand (72) zumindest eine Auskehlung (64) zwischen den ersten und den zweiten leitenden Oberflächen aufweist.

6. Batterie gemäß einem der vorhergehenden Ansprüche 1 bis 5, wobei der Widerstand (72) aus einem Material hergestellt ist, das zumindest Blei aufweist.

## Revendications

1. Batterie comprenant :
- un boîtier (102) ;
- une cellule de stockage contenue dans le boîtier pour recevoir et stocker une charge électrique ; et
- un montant électriquement conducteur connecté à la cellule de stockage et s'étendant hors du boîtier (102) ;
- **caractérisée par**
- une résistance (72) qui fait partie intégrante du montant électriquement conducteur, la résistance (72) ayant une valeur de résistance connue et une première surface conductrice (14) et une deuxième surface conductrice (16), dans laquelle une circulation de courant à partir de la batterie s'effectue à travers la résistance (72) de la première surface conductrice (14) vers la deuxième surface conductrice (16) de la résistance (72) et une circulation de courant vers le montant électriquement conducteur s'effectue à travers la résistance (72) de la deuxième surface conductrice (16) vers la première surface conductrice (14) de la résistance (72) ;
- un premier contact (80) connecté à la première surface conductrice (14) de la résistance (72) ; et
- un deuxième contact (82) connecté électriquement à la deuxième surface conductrice (16) de la résistance (72).

2. Batterie selon la revendication 1, comprenant en outre un ordinateur comprenant :
- une mémoire (26) pour mémoriser la valeur de résistance connue de la résistance (72) ; et
- un processeur (28) programmé pour,
recevoir la chute de tension mesurée par un voltmètre (22) couplé aux premier et deuxième contacts (80, 82),
récupérer la valeur de résistance connue dans la mémoire (26), et
calculer le courant circulant à travers la résistance (72) sur la base de la chute de tension mesurée et de la résistance connue.

3. Batterie selon l'une des revendications 1 et 2 précédentes, dans laquelle la valeur de résistance connue de la résistance (72) est entre environ 50 microhms et environ 200 microhms.

4. Batterie selon l'une des revendications 1 à 3 précédentes, dans laquelle le montant comporte une borne intégrée similaire à un manchon (75).

5. Batterie selon l'une des revendications 1 à 4 précédentes, dans laquelle la résistance (72) comprend au moins un canal (64) entre les première et deuxième surfaces conductrices.

6. Batterie selon l'une des revendications 1 à 5 précédentes, dans laquelle la résistance (72) est réalisée à partir d'un matériau comprenant au moins du plomb.
